Europäisches Patentamt

European Patent Office

Office européen des brevets

(19)

(11) **EP 1 339 143 A2**

(12) **EUROPEAN PATENT APPLICATION**

(43) Date of publication:
    **27.08.2003 Bulletin 2003/35**

(51) Int Cl.⁷: **H01S 5/12**, H01S 5/026

(21) Application number: **03003221.3**

(22) Date of filing: **20.02.2003**

(84) Designated Contracting States:
    **AT BE BG CH CY CZ DE DK EE ES FI FR GB GR
    HU IE IT LI LU MC NL PT SE SI SK TR**
    Designated Extension States:
    **AL LT LV MK RO**

(30) Priority: **21.02.2002 JP 2002044520**

(71) Applicant: **NEC Compound Semiconductor
    Devices, Ltd.
    Kawasaki-shi, Kanagawa (JP)**

(72) Inventor: **Yamazaki, Hiroyuki
    Nakahara-ku, Kawasaki-shi, Kanagawa (JP)**

(74) Representative: **Glawe, Delfs, Moll & Partner
    Patentanwälte
    Postfach 26 01 62
    80058 München (DE)**

(54) **Method of producing a semiconductor laser and optical integrated semiconductor device including the same**

(57)    A semiconductor laser to be produced by a method of the present invention includes a semiconductor substrate, a diffraction grating with an irregular surface formed on the semiconductor substrate, and an optical guide layer grown on the diffraction grating. A period of time over which the optical guide layer grows is selected such that the guide layer does not fill up the valleys of the diffraction grating. Also, the period of time remains substantially constant without regard to the variation of height of the diffraction grating.

FIG. 7

EP 1 339 143 A2

**Description**

BACKGROUND OF THE INVENTION

Field of the Invention

The present invention relates to a method of producing a semiconductor laser and an optical integrated semiconductor device including the same. More particularly, the present invention relates to a method of producing a DFB-LD (Distributed FeedBack Laser Diode) or similar semiconductor laser of the type including a diffraction grating and an optical integrated semiconductor device including the same.

Description of the Background Art

A DFB-LD has a laser oscillation capability with a single wavelength and allows an ultrahigh speed, large capacity optical communication system to be constructed when combined with single-mode optical fibers. Today, there is an increasing demand for a higher data transfer rate for an access optical communication system as well as for a trunk optical communication system. To meet this demand, a modulation rate as high as 10 Gb/sec, for example, must be implemented without temperature control. To improve transfer characteristics at high temperature, the DFB-LD must be designed with a product kL of a coupling coefficient $k$ and a resonator length L that is as large as about 2, so that a modulation characteristic varies little when threshold carrier density increases.

However, an increase in coupling coefficient $k$ increases the probability that spatial hole burning occurs in the direction of resonation and brings about mode jumping. Therefore, to stably implement a DFB-LD satisfying user's needs in an hostile environment in which temperature varies over a broad range of from -40°C to +85°C, it is necessary to accurately control the configuration of a diffraction grating for thereby providing a desired coupling coefficient $k$.

On the other hand, a high-output DFB-LD is so designed as to reduce the coupling coefficient $k$ in order to increase slope coefficient. However, if the coupling coefficient k is excessively small, then it is likely that optical output saturates due to an increase in threshold carrier density, obstructing high-output operation. In light of this, to provide a high-output DFB-LD with a desirable high-output characteristic, the coupling coefficient k must be matched to a narrow range of production tolerance.

It is a common practice to control the product kL of a DFB-LD mainly by accurately controlling the height of a diffraction grating. For example, a first method forms a buried diffraction grating by causing thin InP to grow at both sides of an optical guide layer and then etching a diffraction grating, as taught by Takemoto et al. in "Journal of Lightwave Technology", Vol., 7, No. 12, pp. 2072-2077, December 1989. A second method produces a distributed gain-coupled feedback semiconductor laser using InAsP formed by mass transport as an absorption layer as taught in Japanese Patent Laid-Open Publication No. 8-274406

However, the technologies taught in the above documents are not satisfactory as to control over the coupling coefficient $k$ of a DFB-LD, as will be described specifically later with reference to the accompanying drawings. Particularly, as for a DFB-LD, oscillation characteristics and single-mode yield noticeably vary in accordance with the variation of the coupling coefficient $k$, obstructing quantity production.

Technologies relating to the present invention are also disclosed in Japanese Patent Laid-Open Publication Nos. 2-105593 and 6-252502.

SUMMARY OF THE INVENTION

It is an object of the present invention to provide a method of producing a semiconductor device whose coupling coefficient $k$ can be accurately controlled and having uniform characteristics and an optical integrated semiconductor device including the same.

A semiconductor laser to be produced by a method of the present invention includes a semiconductor substrate, a diffraction grating with an irregular surface formed on the semiconductor substrate, and an optical guide layer grown on the diffraction grating. A period of time over which the optical guide layer grows is selected such that the guide layer does not fill up the valleys of the diffraction grating. Also, the period of time remains substantially constant without regard to the variation of height of the diffraction grating.

BRIEF DESCRIPTION OF THE DRAWINGS

The above and other objects, features and advantages of the present invention will become more apparent from the following detailed description taken with the accompanying drawings in which:.

FIG. 1 is a view showing a conventional semiconductor laser;

FIG. 2 is a view showing another conventional semiconductor laser;

FIG. 3 is a view showing a further conventional semiconductor device;

FIGS. 4A and 4B are views each showing a particular configuration of a diffraction grating for describing the advantages of the present invention;

FIG. 5 shows a calculation model applied to the valleys of a diffraction grating unique to the present invention;

FIG. 6 is a graph showing a relation between the depth of the diffraction grating of the present invention and the coupling coefficient $k$;

FIG. 7 is a view showing a first embodiment of the semiconductor laser in accordance with the present invention;

FIGS. 8A through 8C show a sequence of steps for producing the semiconductor laser of the first embodiment;

FIGS. 9A through 9E are perspective views associated with FIGS. 8A through 8C;

FIG. 10 is a view showing a second embodiment of the semiconductor laser in accordance with the present invention;

FIG. 11 is a plan view showing a mask pattern used in the second embodiment; and

FIG. 12 is a plan view showing a mask pattern used in a third embodiment of the present invention.

DESCRIPTION OF THE PREFERRED EMBODIMENTS

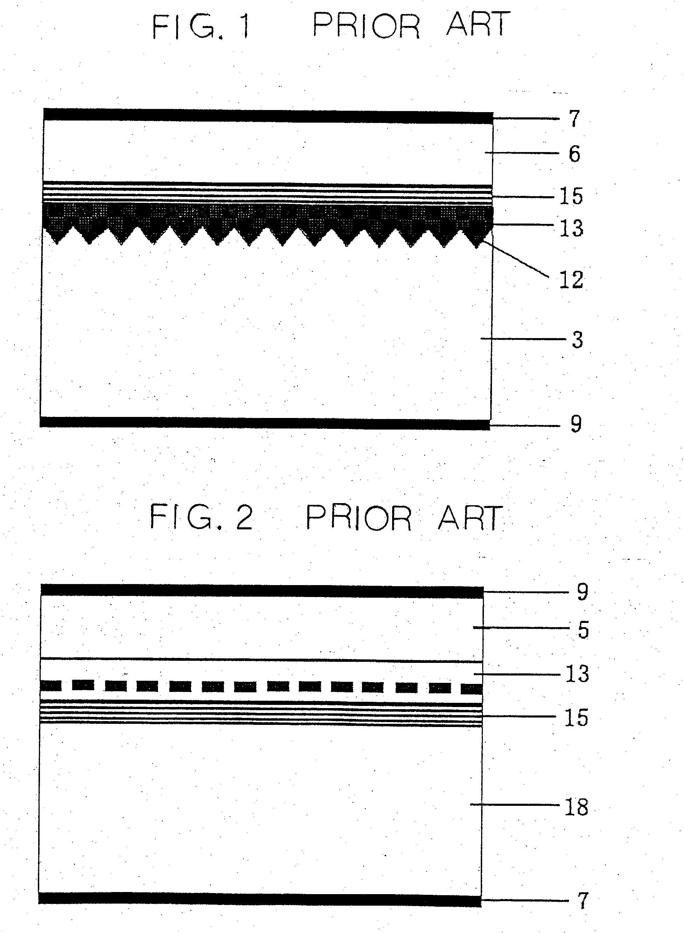

To better understand the present invention, brief reference will be made to a conventional DFB-LD, shown in FIG. 1. As shown, the DFB-LD includes an n-InP substrate 3 on which a diffraction grating 12 is formed and buried in an optical guide layer 13. An active layer 15 and a p-InP current blocking layer 6 are sequentially stacked on the optical guide layer 13 in this order. An n-type electrode 9 is formed on the bottom of the n-InP substrate 3 while a p-type electrode 7 is formed on the current blocking layer 6. To produce the DFB-LD, after the diffraction grating 12 has been formed on the n-InP substrate 3 by wet etching, it is caused to wait until MOVPE (Metal Oxide Vapor Phase Epitaxial) growth and blunted to a desired height thereby. Subsequently, the optical guide layer 13 is caused to grow. This procedure controls mass transport in order to vary growth waiting conditions.

However, with the above procedure, it is difficult to accurately control the height of the diffraction grating 12. The height of the diffraction grating 12 varies by about ±30 % among the processed batches of semiconductor wafers, causing the previously mentioned product kL to noticeably vary. This has critical influence on the oscillation characteristics and single-mode yield.

FIG. 2 shows the structure of a buried diffracting grating implemented by the first, conventional accurate control method stated earlier. As shown, after an active layer 15 has been formed on a p-InP substrate 18, an optical guide layer 13 is caused to grow on the active layer 15. The first method can accurately control the thickness of the optical guide layer 13, which has critical influence on the coupling coefficient $k$, by crystal growth. However, the problem with the diffraction grating formed by, e.g., wet etching is that the ratio between the peaks and valleys of the diffraction grating is apt to noticeably vary, greatly influencing the coupling coefficient $k$ and thereby obstructing accurate control.

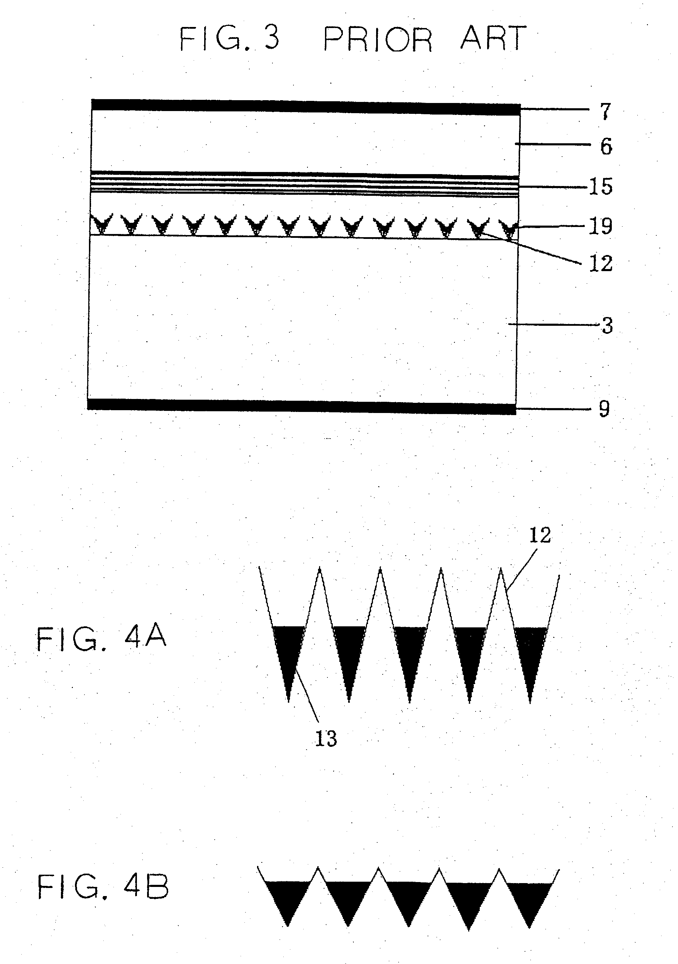

FIG. 3 shows the structure of a distributed gain-coupled feedback laser diode implemented by the second, conventional accurate control method also stated earlier. As shown, before crystal growth, arsine ($AsH_3$) and phosphine ($PH_3$) are caused to flow on a diffraction grating 12. Thereafter, the diffraction grating 12 is caused to wait for a preselected period of time. Although the diffraction grating deforms during the waiting time, an InAsP degenerated layer 19 grows in the valleys of the diffraction grating at the same time. InAsP has a band gap of 1.3 μm and involves an absorption loss for light whose wavelength is as long as 1.3 μm or above. by positively using such an absorption loss, the second method implements a distributed gain-coupled feedback type of operation. However, a device producing method positively using mass transport, which is extremely unstable, is questionable from the stability standpoint. Moreover, the composition of InAsP, which grows to form the degenerated layer 19, is difficult to control, so that the absorption of InAsP itself is likely to vary and bring about the variation of the coupling coefficient $k$.

In light of the above, the present invention realizes accurate control over the coupling coefficient $k$ not by controlling the height of a diffraction grating, but by maintaining the sectional area of an optical guide layer grown in the values of a diffraction grating constant throughout all wafers without regard to the height of the grating. With this scheme, the present invention remarkably improves the reproducibility and uniformity of oscillation characteristics as well as single-mode yield.

FIGS. 4A and 4B each show a particular configuration of a diffraction grating 12, i.e., a particular condition wherein an optical guide layer 13 grows in accordance with the depth of the diffraction grating 12. By maintaining the growing time of the optical guide layer 13 in the valleys of the diffraction grating 12 constant without regard to the height of the grating 12, it is possible to uniform the sectional area inclusive of the thickness of the optical guide layer 13.

More specifically, when the diffraction grating 12 is deep, as shown in FIG. 4A, the optical guide layer 13 concentrates on the values of the grating 12. In this condition, great perturbation in refractive index occurs in the valleys, but duty decreases in portions where the refractive index varies. By contrast, when the diffraction grating 12 is shallow, as shown in FIG. 4B, the optical guide layer 13 grows from the valleys to a level close to the peaks, causing small perturbation in refractive index to occur over a broad range. Such perturbation implements a great duty in the portions where refractive index varies. Consequently, in the configuration shown in FIG. 4B, perturbation and duty variation act in a direction in which they cancel the variation of the coupling coefficient $k$. This successfully absorbs the variation of height of the diffraction grating 12 occurring due to mass transport during etching and waiting that precedes growth, thereby remarkably improving control over the coupling coefficient $k$.

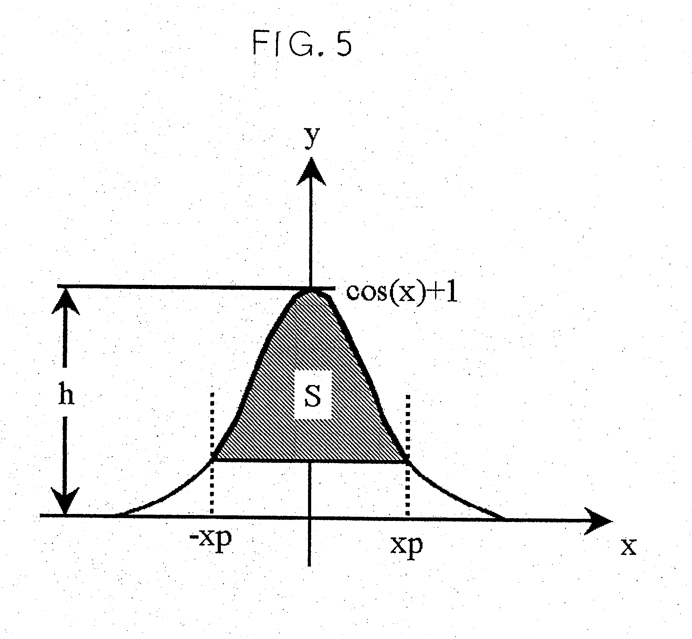

Hereinafter will be described a method of calculating the coupling coefficient $k$ and the results of calculation obtained with the optical guide layer 13 having a constant sectional area stated above. First, equations for determining the configuration of the diffraction grating 12 whose valleys have a constant area will be described. FIG. 5 shows a calculation model for determining a condition that makes the sectional area of the valleys constant. While FIG. 5 shows one of the valleys in an upside-down position, the valley has a sectional area S indicated by shading. The sectional area S is expressed as:

$$S = \int_{-xp}^{xp}\{\cos(x)+1-\cos(xp)\}dx \qquad\qquad \text{Eq. (1)}$$

By integrating the Eq. (1), there is produced:

$$S=2\sin(xp)-2\cos(xp)xp \qquad\qquad \text{Eq. (2)}$$

By integrating cos (x) + 1 over a single period, there is obtained $2\pi$. Therefore, xp that makes the sectional area constant when h is varied is produced by:

$$\frac{\pi}{h}=\sin(xp)-\cos(xp)xp \qquad\qquad \text{Eq. (3)}$$

It is to be noted that the Eq. (3) was solved by iterative calculations because an analytical method is not applicable to xp.

As for the coupling coefficient $k$, Fourier integration is effected for the period of the linear diffraction grating:

$$K = \frac{\pi}{\lambda}\frac{2}{\Lambda}\int_{-\frac{\Lambda}{2}\frac{xp}{\pi}}^{\frac{\Lambda}{2}\frac{xp}{\pi}} n(z)\cos(2\pi\frac{z}{\Lambda})dz \qquad\qquad \text{Eq. (4)}$$

where n(z) denotes the variation of a refractive index ascribable to the diffraction grating 12, and z denotes the direction of a resonator. The variation n(z) is produced by:

$$n(z) = \frac{n_2-n_1}{2}\left\{\cos(2\pi\frac{z}{\Lambda})+1-\cos(xp)-1\right\}$$

$$= \frac{n_2-n_1}{2}\left\{\cos(2\pi\frac{z}{\Lambda})-\cos(xp)\right\} \qquad\qquad \text{Eq. (5)}$$

To produce the Eq. (5), considering the fact that the optical guide layer 13 grows only in the valleys of the diffraction grating 12, it is assumed that the refractive index does not to vary in the portions other than the valleys. This is why cos (xp) is added to the Eq. (5). In this sense, in the Eq. (5), n1 denotes an equivalent, waveguide refractive index in a portion where the optical guide layer 13 is absent, and n2 denotes a waveguide refractive index that would hold if the guide layer 13 were formed up to the peaks of the diffraction grating 12.

To summarize the above procedure, the Eq. (3) is used to determine an integration section in which the optical guide layer 13 in the valleys of the diffraction grating 12 is constant. Subsequently, the equivalent, waveguide refractive index of the peaks of the diffraction grating 12 and that of the valleys are calculated. Thereafter, Fourier integration represented by the Eq. (4) is effected over the above integration section to thereby determine a coupling coefficient $k$.

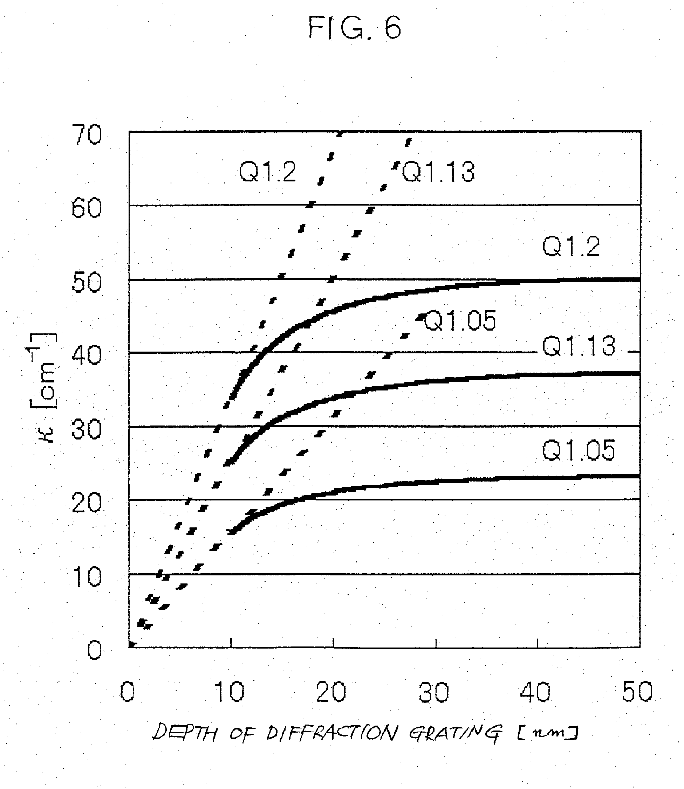

FIG. 6 shows a relation between the depth of the diffraction grating 12 and the coupling coefficient k determined by maintaining the sectional area of the optical guide layer 13 constant. In FIG. 6, dotted curves indicate the results of calculation effected with the conventional structure in which the optical guide layer is caused to grow up to the peaks of the diffraction grating. Solid curves indicate the results of calculation effected with the diffraction grating 12 of the present invention in which the optical guide layer 13 does not reach the peaks of the grating 12. Numerical values attached to Q each indicate a particular wavelength composition of the InGaAsP optical guide layer grown on the diffraction grating.

As FIG. 6 indicates, in the conventional structure, the coupling coefficient $k$ noticeably varies in proportion to the depth of the diffraction grating, i.e., in accordance with even the slightest variation of the height of the diffraction grating. In the structure of the present invention, at a position where the diffraction grating 12 is 14.3 nm deep, i.e., the thickness of the optical guide layer 13 is 70 % of the depth of the grating 12, the coupling coefficient $k$ varies relative to the depth of the grating only by a ratio which is as small as about one-third of the variation ratio of the conventional structure. Further, so long as the depth of the diffraction grating 12 is 20 nm or above, preferably 30 nm or above, the variation of the coupling coefficient is further reduced relative to the variation of the depth of the diffraction grating 12. This reflects the diffraction grating structure unique to the present invention in which the coupling coefficient $k$ remains substantially constant if the sectional area is constant.

In accordance with the method of the present invention, a period of time over which the optical guide layer 13 grows is selected such that the layer 13 does not fill up the valleys of the diffraction grating 12. In addition, the above period of time is maintained substantially constant throughout all wafers without regard to the height of the diffraction grating 12. This allows the maximum thickness of the optical guide layer 13 formed in the valleys of the diffraction grating 12 smaller than the height of the grating 12, and maintains the sectional area of the layer 13 substantially constant in the direction of thickness. Consequently, the coupling coefficient $k$ remains substantially constant and noticeably improves production tolerance.

Laid-Open Publication No. 8-274406 mentioned earlier teaches a structure for selectively forming InGaAsP in the valleys of a diffraction grating. This structure, however, contemplates to implement a distributed gain-coupled feedback operation by causing an InAsP degenerated layer to grow in the valleys of a diffraction grating and positively using an absorption loss as to light whose wavelength is longer than the InAsP band gap. Laid-Open Publication No. 2-105593 also mentioned earlier discloses a semiconductor laser structure in which a guide layer is formed on a diffraction grating by the crystal growth of liquid crystal and provided with thickness short of the height of the peaks of the grating. The object of this structure is to reduce a light absorption loss ascribable to an optical guide layer by making the thickness of an optical guide layer smaller than the height of the peaks of a diffraction grating.

Therefore, neither one of the documents stated above even suggests the crux of the present invention, i.e., an optical guide layer growing method coping with irregularity in the height of a diffraction grating and to realize accurate control over the coupling coefficient k and improvement in production tolerance by maintaining the sectional area of an optical guide layer constant.

Preferred embodiments of the present invention will be described hereinafter.

First Embodiment

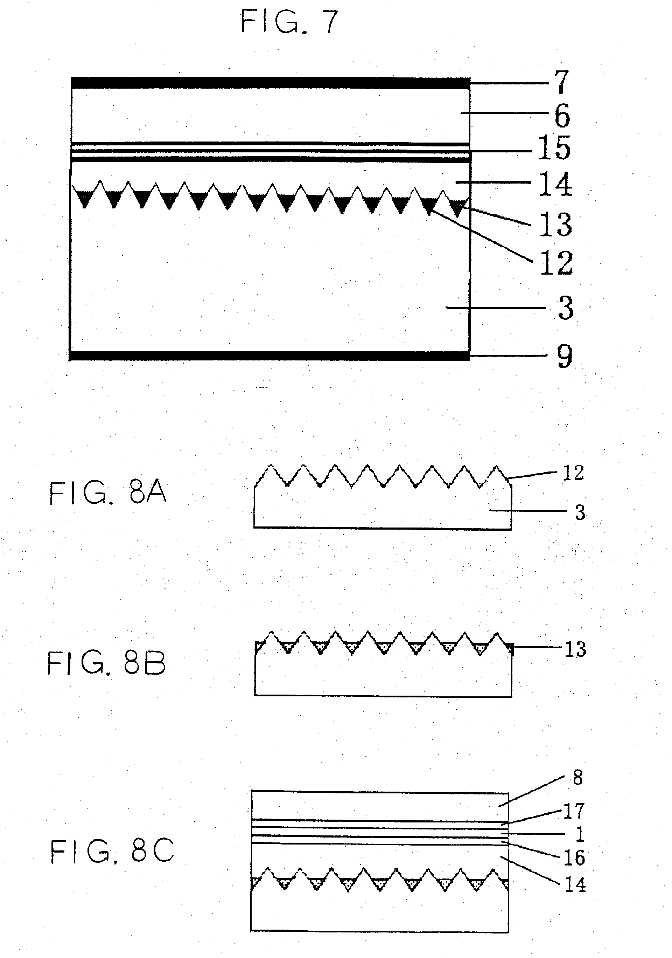

Referring to FIG. 7, a semiconductor device embodying the present invention is shown and implemented as a DFB-LD. As shown, the DFB-LD includes an n-InP substrate 3 and a diffraction grating 12 formed on the substrate 3. An optical guide layer 13 is formed in the valleys of the diffraction grating 12 and provided with thickness smaller than the height of the grating 12. An n-InP buffer layer 14 is formed on the optical guide layer 13 in such a manner as to bury the diffraction grating 12. Further, an active layer 15 and a p-InP current blocking layer 6 are sequentially formed on the n-InP buffer layer 14 in this order. An n-type electrode 9 is formed on the bottom of the n-InP substrate 3 while a p-type electrode 7 is formed on the top of the p-InP current blocking layer 6.

Reference will be made to FIGS. 8A through 8C and 9A through 9E for describing a method of producing the DFB-LD of the illustrative embodiment. First, a resist pattern, not shown, is formed on the (011) surface of the n-InP substrate 3 by EB (Electron Beam) exposure for forming the diffraction grating 12. In the illustrative embodiment, a $\lambda$/

4 phase shift is applied to the resist pattern in order to increase single-mode yield. A period and a drawing width are 2,000 Å and 10 μm, respectively. Subsequently, wet etching is effected by using the resist pattern as a mask so as to form the diffraction grating 12 on the n-InP substrate 3. FIG. 8A shows the diffraction grating 12 in an enlarged scale.

After the diffraction grating 12 has been formed, 10 nm thick, $SiO_2$ growth blocking films 2 are formed by thermal CVD (Chemical Vapor Deposition). Subsequently, a resist pattern for selective MOVPE growth is formed by photolithography. The growth blocking films 2 are then etched out by diluted hydrofluoric acid to thereby complete a substrate for the growth of the optical guide layer 13. The growth blocking films 2 were 5 μm wide each while a gap between them was 5 μm wide. The InGaAsP optical guide layer 13 with a wavelength composition of 1.1 μm is caused to grow on the diffraction grating 12 by selective MOVPE growth. The resulting configuration is shown in FIG. 9A in an isometric view. Also, the diffraction grating portion is shown in FIG. 8B in an enlarged section.

A period of time over which the optical guide layer 13 grows is such that the layer 13 does not fill up the valleys of the diffraction grating 12, and remains substantially constant although the height of the diffraction grating 12 may vary from one wafer to another wafer. In the illustrative embodiment, the growing time is selected to be 2.7 seconds. More specifically, the growing time is so selected as to make the thickness of the optical guide layer 13 smaller than the height of, among the diffraction gratings 12 of different wafers, the diffraction grating 12 having the minimum height. This substantially uniforms the growing time throughout all wafers.

After a waiting time for temperature elevation, the diffraction grating 12 is 30 nm high and varies up to about ±30 % among batches. Therefore, the height of the diffraction grating 12 varies in the range of from 20 nm to 40 nm. In the illustrative embodiment, the maximum thickness of the optical guide layer 13 is selected to be 10 nm, which is 50 % of the lower limit of 20 nm as to the height of the diffraction grating 12, so that the coupling coefficient $k$ varies little despite irregularity in the height of the diffraction grating 12.

Subsequently, the n-InP buffer layer 14 is caused to grow on the optical guide layer 13 to thickness of 0.1 μm by selective MOVPE growth. InGaAsP is caused to grow on the n-InP buffer layer by epitaxial growth to 50 nm, constituting a first SCH layer 16 having a 1 μm wavelength composition. Thereafter, an MQW (Multiple Quantum Well) layer 1, a 50 nm thick, second SCH layer 15 of InGaAsP with a 1.1 μm wavelength composition, and a 100 nm p-InP cladding layer 8 are sequentially stacked by epitaxial growth in this order. The resulting stack is shown in FIG. 8C.

The MQW layer 1 is made up of InGaAsP well layers each having a 1.4 μm wavelength composition and an InGaAsP barrier layer sandwiched between the well layers and having a 1.1 μm wavelength composition. The MQW layer 1 has a period of 7 and an oscillation frequency of 1.3 μm. Each well layer and the barrier layer are 7 nm thick and 10 nm thick, respectively.

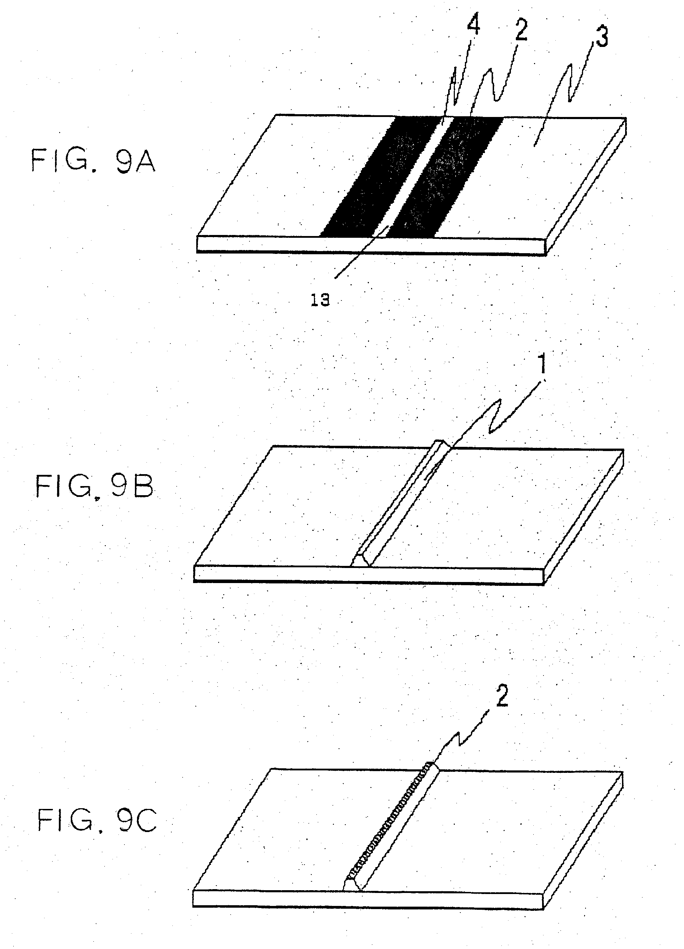

The crystals of the layers stated above do not grow on the growth blocking films 2, but selectively grow in the gap 3 on the n-InP substrate 3. After the waveguide including the MQW layer 1 has selectively grown, the $SiO^2$ growth blocking films 2 are removed by hydrofluoric acid, as shown in FIG. 9B.

Subsequently, an $SiO_2$ growth blocking layer is again deposited over the entire surface of the stack shown in FIG. 9B. This growth blocking layer is then selectively removed by hydrofluoric acid by a self-alignment process such that the growth blocking film 2 remains only on the top of the waveguide, which is directly formed. The resulting configuration is shown in FIG. 9C. Thereafter, as shown in FIG. 9D, MOVPE growth is again effected by using the growth blocking film 2 as a mask to thereby sequentially form the p-InP current blocking layer 6 and an n-InP current blocking layer 5, which are 0.7 m thick and 0.7 mm thick, respectively.

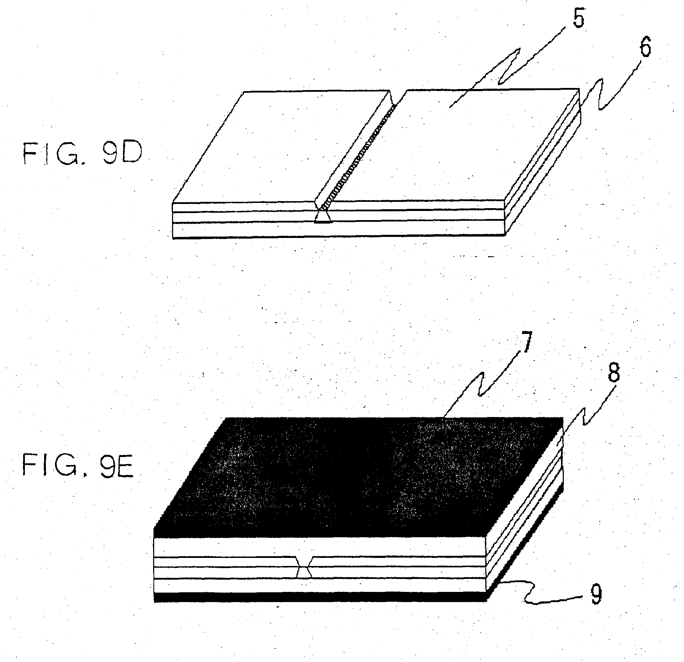

Subsequently, after the grow blocking film 2 on the waveguide has been removed, the 3 μm thick, p-InP cladding layer 8 and a 0.3 μm thick, InGaAs cap layer are sequentially caused to grow in this order. After the p-type electrode 7 and n-type electrode 9 formed of TiAu have been formed on opposite sides of the stack, the stack is subject to electrode alloying at 430°C for thereby completing the DFB-LD, as shown in FIG. 9E.

Although the optical guide layer 13 partly grows as far as the peaks of the diffraction grating 12, such part of the optical guide layer 13 does not noticeably impair accurate control over the coupling coefficient $k$ achievable with the illustrative embodiment. The illustrative embodiment may be modified to fully obviate the growth of the optical guide layer 13 up to the peaks of the diffraction grating 12, as will be described hereinafter.

The sequence that causes the InGaAsP optical guide layer 13 to grow on the InP diffraction grating 12, but stop growing before reaching the peaks of the diffraction grating 12, is characterized in that the growth of the guide layer 13 concentrates in the valleys and reaches the peaks little. This is because the growth rate is higher on the [111] and other higher-order surfaces than on the [001] surface. More specifically, at the initial stage of MOVPE growth on the diffraction grating 12, the optical guide layer 13 grows little on the [001] surface, so that growth on the higher-order surface is predominant. As a result, the optical guide layer 13 first fills up the valleys having the higher-order surfaces on their sides, and then starts growing on the peaks, i.e., the [001] surface. Stated another way, the optical guide layer 13 selectively grows only in the valleys at the initial stage. Therefore, by causing the optical guide layer 13 to selectively grow only in the valleys and then switching the quaternary growth to InP before the guide layer 13 reaches the peaks, it is possible to make the optical guide layer 13 on the peaks thinner than the layer 13 in the valleys by at least one-half. It follows that the variation of refractive index can be implemented mainly by the optical guide layer 13.

The coupling coefficient $k$ is estimated to be 31 cm$^{-1}$. In the illustrative embodiment, when the height of the diffraction grating 12 varies by ±30 %, i.e., in the range of from 20 nm to 40 nm, the coupling coefficient $k$ also varies in the range of 29 to 32, as FIG. 6 indicates, so that the variation ratio is expected to be ±5 %. By contrast, it is necessary with the conventional method, which causes the optical guide layer to fill up the valleys of the diffraction grating, to make the height of the grating 12 as small as 15 nm in order to implement the coupling coefficient $k$ of 31 cm$^{-1}$. This, however, causes the coupling coefficient $k$ to vary in the range of from 20 to 41 for the variation range of the height of the diffraction grating 12 between 10 nm and 20 nm, making the variation ratio as high as ±34 %. It will therefore be seen that the method of the present invention reduces the variation of the coupling coefficient $k$ to about one-seventh of the variation of the conventional method.

For experiment, the device of the illustrative embodiment was sliced in such a manner as to locate the λ/4 phase shift at the center and had its opposite ends coated with non-reflection SiON films with reflectance of 0.1 %. The experiment showed that the coupling coefficient $k$ estimated from the stop band spectrum and produce kL were respectively 31 cm$^{-1}$ and 1.3, which were identical with the designed values. Further, a threshold current of 12 mA and a slope efficiency of 35 W/A were achieved at room temperature, insuring desirable oscillation characteristics. Moreover, the adequate product kL and the adequate reflectance of 0.1 % realized single-mode yield as high as 98 %.

Second Embodiment

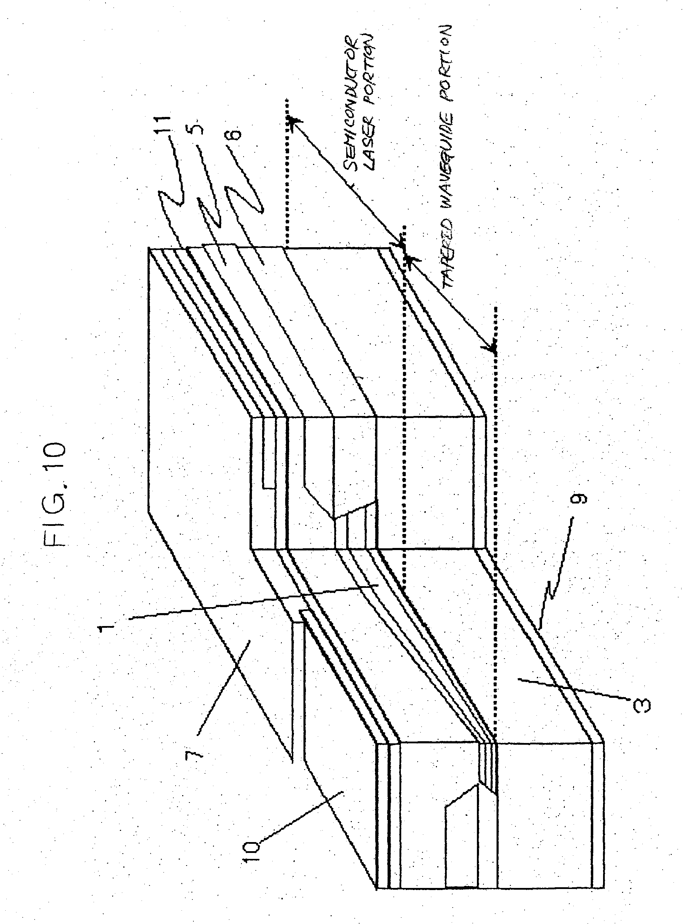

FIG. 10 shows an alternative embodiment of the present invention and implemented as SSC-DFB-LD (Spot-Size-Converter integrated Distributed FeedBack Laser Diode). As for the production process, the illustrative embodiment is similar to the previous embodiment except that a tapered waveguide, which decreases in thickness toward the emission end, and a semiconductor laser portion are formed at the same time.

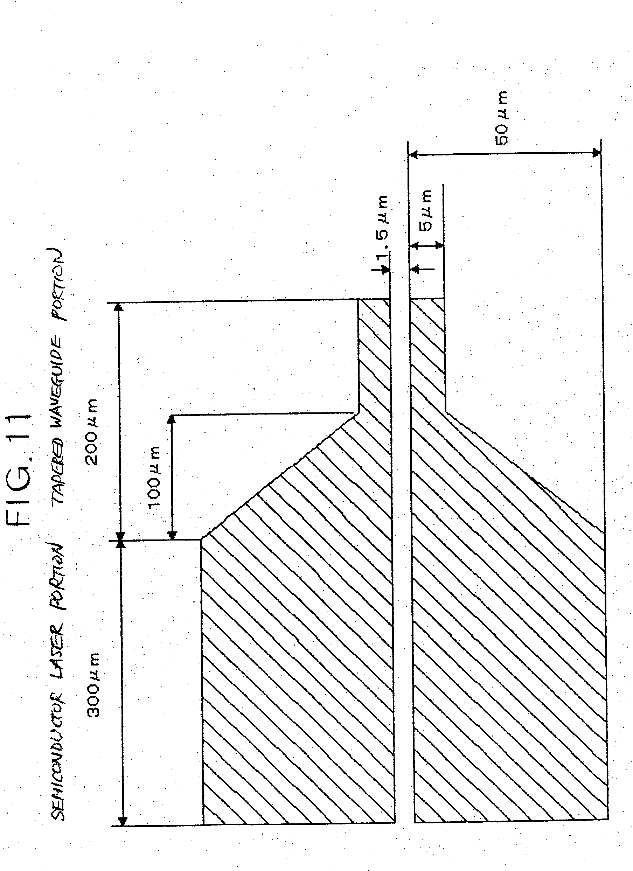

More specifically, in the illustrative embodiment, the diffraction grating 12 is formed only beneath the MQW active layer. The MQW active layer and tapered waveguide layer are collectively formed by selective MOVPE growth in the gap between oxide film masks. In the event of crystal growth on the diffraction grating 12, the optical guide layer 12 is caused to grow only in the valleys of the grating 12 while being prevented from growing to the peaks of the grating 12. For experiment, the height of the diffraction grating 12 and the maximum thickness of the optical guide layer 13 were respectively selected to be 30 nm and 15 nm, as in the first embodiment, after the waiting period for temperature elevation. Also, the substantially constant growing time of the optical guide layer 13 unique to the present invention was selected to be 4.2 seconds. FIG. 11 shows the pattern of the growth blocking films 2 used for selective growth.

The semiconductor laser portion and tapered waveguide portion were 300 μm long and 200 μm long, respectively. The growth blocking layers 2 each were 50 μm wide in the semiconductor laser portion or sequentially decreased in width from 50 μm to 5 μm toward the emission end in the tapered waveguide portion. The growth blocking films 2 so decreasing in width toward the omission end implement a tapered structure in which the thickness of the waveguide decreases toward the emission end. In addition, the waveguide has a minimum of diffusion loss because the sides of the tapered waveguide are (111) crystal surfaces. After the collective formation of the MQW layer or active layer 1 and tapered waveguide layer, the SSC-DFB-LD can be produced by the same device production process as in the first embodiment. As shown in FIG. 10, in the illustrative embodiment, the p-type electrode 7 extends to the emission portion and part of the tapered waveguide so as to inject a current in part of the tapered waveguide. This successfully obviates an increase in absorption loss in the above part of the tapered waveguide. The front end and rear end were provided with a 0.1 % or non-reflection coating and a 90 % or high-reflection coating, respectively.

Experiments showed that the SSC-DFB-LD of the illustrative embodiment performed stable single-mode oscillation in the temperature range of from -40°C to 85°C. The threshold currents at 25°C and 85°C were as small as 4. mA and 12 mA, respectively. Further, a drive current at 80°C was as small as 40 mA for 10 mW and had a fair chance of implementing an optical module not needing temperature control. While conventional semiconductor lasers have a horizontal radiation angle of 33° and a vertical radiation angle of 35°, the illustrative embodiment reduced both of the radiation angles to 10° because of the integration of the tapered waveguide. The illustrative embodiment therefore realized a desirable coupling characteristic as well, i.e., the minimum coupling loss to a single-mode fiber having a spot size of 10 μm was as small as 1.5 dB.

Third Embodiment

This embodiment is implemented as an EML (Electroabsorption Modulator integrated Laser) in which a DFB-LB with a diffraction grating and an electroabsorption modulator are integrated together. The illustrative embodiment differs from the first embodiment as to the pattern of the growth blocking films 2 for selective MOVPE growth and the use of the InP substrate on which the diffraction grating 12 is locally formed as in the second embodiment.

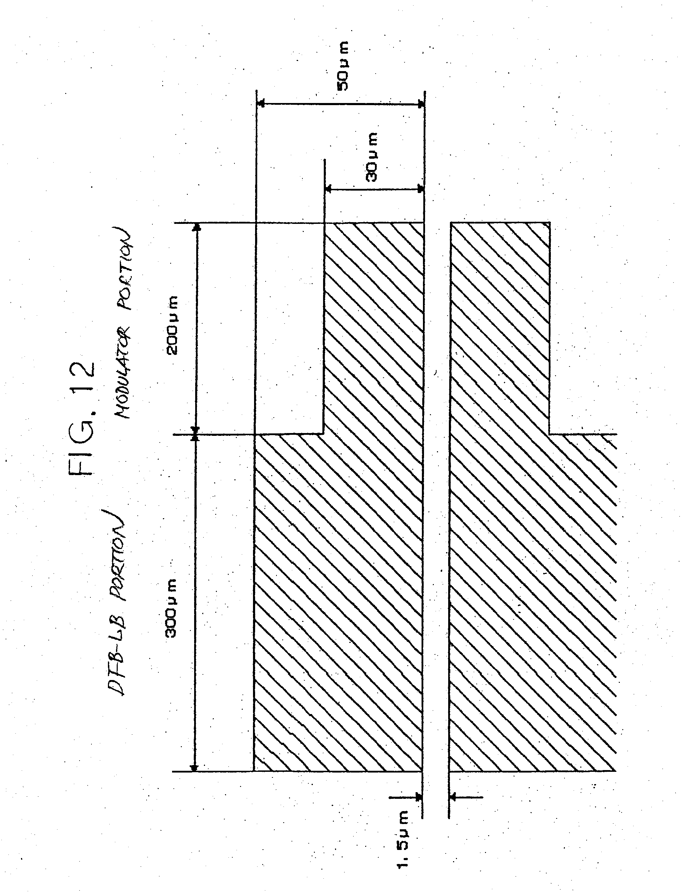

FIG. 12 shows a mask pattern for collectively forming the active layer 1 and absorption layer of the EML of the illustrative embodiment. In the illustrative embodiment, the DFB-LD had a resonator length of 300 μm while the

modulator portion was 200 μm long. The growth blocking films each were 50 mm wide in the DFB-LD portion formed on the diffraction grating substrate or 30 μm wide in the modulator portion. The active layer 1 and absorption layer were collectively formed in a 1.5 μm wide gap by selective MOVPE growth. As for the position beneath the active layer, the optical guide layer 13 was caused to grow only in the valleys of the diffraction grating 12. The optical guide layer 13 was 8 nm thick in flat portions. InGaAsP with a wavelength composition of 1.13 μm was applied to the optical guide layer 13. Again, the growing time of the optical guide layer 13 was selected such that the layer 13 did not fill up the valleys of the diffraction grating 12, and remained substantially constant even when the height of the diffraction grating 12 differed from one wafer to another wafer.

After the growth of the optical guide layer 13, a 0.1 μm thick n-InP layer and an MQW layer were sequentially caused to grow in this order. A wavelength shift ascribable to the variation of width of the growth blocking films was designed to be 70 nm, which was adequate for the electroabsorption modulator. After the selective MOVPE growth, the EML can be fabricated by the same device production process as in the first embodiment. The difference is that the illustrative embodiment formed an electrically independent electrode between the DFB-LD portion and the modulator portion, and used an Fe-doped InP high-resistance layer as the current blocking layer.

The illustrative embodiment achieved a product kL of 1.5 identical with the designed value and implemented single-mode yield of 80 % or above when the product kL was adequately controlled. The threshold current and slope efficiency were 5 mA and 0.2 W/A, respectively. When a voltage of 2 V was applied to the absorption layer, a quenching ratio was as low as 20 dB. Further, a desirable eye opening was achieved even when 2.5 Gb modulation was effected. When a 600 km, normal fiber transfer test was conducted with the integrated device of the illustrative embodiment, power penalty was found to be as small as 0.5 dB.

Fourth Embodiment

In the illustrative embodiment, the MQW layer was formed by selective MOVPE growth. The illustrative embodiment is effective not only with the structure of the first embodiment, but also with the conventional structure in which a waveguide is formed by wet etching or dry etching using $SiO_2$ as a mask. As for the conventional structure, the illustrative embodiment will cause the optical guide layer 13 to grow on the substrate with the diffraction grating 12 formed thereon in the range of 20 % or above to 70% or below of the height of the diffraction grating 12, thereby causing the refractive index to periodically vary.

In the illustrative embodiment, the optical guide layer 13 is formed of InGaAsP with a wavelength composition of 1.13 μm. Again, the growing time of the optical guide layer 13 is selected to such that the layer 13 does not fill up the valleys of the diffraction grating 12, and remains substantially constant even when the height of the grating 12 differs from one wafer to another wafer. After the growth of the optical guide layer 13, n-InP for a 0.1 μm MQW active layer and 0.1 μm p-InP were sequentially caused to growth in this order. To form a waveguide, a 5 μm wide $SiO_2$ stripe is formed on the substrate and then etched. Subsequently, a p-type and an n-type current blocking layer are sequentially caused to grow in this order by MOVPE growth again using $SiO_2$ as a mask. After the $SiO_2$ mask has been removed, a p-InP cladding layer is caused to grow, and then the customary electrode process is executed to complete the device.

As for the current blocking layers and p-InP cladding layer, LPE (Liquid Phase Epitaxial growth) may be used in place of MOVPE growth. The illustrative embodiment was comparable in oscillation characteristic with the first embodiment when the λ/4 phase shift was located at the center of the device and when the same resonator length and end structure as in the first embodiment were used.

Fifth Embodiment

This embodiment is also implemented as an EML and also differs from the first embodiment as to the pattern of the growth blocking films 2 for selective MOVPE growth and the use of the InP substrate on which the diffraction grating 12 is locally formed as in the second embodiment.

FIG. 12 shows a mask pattern for collectively forming the DFB-LD layer 1 and absorption layer unique to the illustrative embodiment. In the illustrative embodiment, the DFB-LD portion had a resonator length of 300 μm while the modulator portion was 200 μm long. The growth blocking layer was 50 μm wide in the DFB-LD portion or 30 μm in the modulator portion. The active layer 1 and absorption layer were formed in the 1.5 μm wide gap by selective MOVPE growth. At the position beneath the active layer 1, the optical guide layer 13 was caused to grow only in the valleys 12 of the diffraction grating 12. The optical guide layer 13 was 8 nm thick in the flat portions. InGaAsP with a wavelength composition of 1.13 μm was used for the optical guide layer 13. As for the growing time, the illustrative embodiment is identical with the previous embodiments.

After the growth of the optical guide layer 13, n-InP was caused to grow to 0.1 μm, and then the MQW layer was caused to grow.

In summary, in accordance with the present invention, the growing time of an optical guide layer is selected such that an optical guide layer does not fill up the valleys of a diffraction grating, and remains substantially constant throughout all wafers. It is therefore possible to make the maximum thickness of the optical guide layer in the valleys smaller than the height of the diffraction grating and to maintain the sectional area of the guide layer in the direction of thickness constant. It follows that the coupling coefficient $k$ remains constant and improves production tolerance to a noticeable degree. The .present invention therefore realizes a DFB-LD whose coupling coefficient $k$ can be extremely accurately controlled. The oscillation characteristic of such a DFB-LD and single-mode yield vary. little, so that the uniformity of various characteristics including reproducibility is remarkably improved.

Further, the present invention is applicable to all semiconductor layers of the type including a diffraction grating and noticeably improves control over the coupling coefficient $k$ in production methods therefor. It follows that the present invention is applicable to not only production methods for DFB-LDs and other singular devices, but also production methods for modulator-integrated light sources, distributed Bragg-reflection semiconductor lasers and so forth.

Various modifications will become possible for those skilled in the art after receiving the teachings of the present disclosure without departing from the scope thereof.

**Claims**

1.  In a method of producing a semiconductor laser comprising a semiconductor substrate, a diffraction grating with an irregular . surface formed on said semiconductor substrate, and an optical guide layer grown on said diffraction grating, a period of time over which said optical guide layer grows is selected such that said optical guide layer does not fill up valleys of said diffraction grating, and remains substantially constant without regard to a variation of height of said diffraction grating.

2.  The method as claimed in claim 1, wherein said optical guide layer has a substantially constant sectional area in a plane containing a maximum thickness of said optical guide layer.

3.  The method as claimed in claim 1, wherein said optical guide layer has a maximum thickness which is 70 % or below of the height of said diffraction grating.

4.  The method as claimed in claim 1, wherein said semiconductor layer has an operation wavelength of 0.3 μm to 1.7 μm.

5.  In a method of producing a waveguide type integrated semiconductor device including a semiconductor laser that comprises a semiconductor substrate, a diffraction grating with an irregular surface formed on said semiconductor substrate, and an optical guide layer grown on said diffraction grating, a period of time over which said optical guide layer grows is selected such that said optical guide layer does not fill up valleys of said diffraction grating, and remains substantially constant without regard to a variation of height of said diffraction grating, and
    side walls of said optical waveguide are (111) crystal surfaces.

6.  The method as claimed in claim 5, wherein said optical guide layer has a substantially constant sectional area in a plane containing a maximum thickness of said optical guide layer.

7.  The method as claimed in claim 5, wherein said optical guide layer has a maximum thickness which is 70 % or below of the height of said diffraction grating.

8.  The method as claimed in claim 5, wherein said semiconductor layer has an operation wavelength of 0.3 μm to 1.7 μm.

9.  In a method of fabricating a waveguide type integrated semiconductor device including a semiconductor laser that comprises a semiconductor substrate, a diffraction grating with an irregular surface formed on said semiconductor substrate, and an optical guide layer grown on said diffraction grating, a period of time over which said optical guide layer grows is selected such that said optical guide layer does not fill up valleys of said diffraction grating, and remains substantially constant without regard to a variation of height of said diffraction grating, and
    said semiconductor devices comprises at least one of said semiconductor layer, a distributed reflection semiconductor layer, a tapered waveguide, an optical modulator, a photodetector, an optical switch, and an optical waveguide.

10.  The method as claimed in claim 9, wherein said optical guide layer has a substantially constant sectional area in a plane containing a maximum thickness of said optical guide layer.

11. The method as claimed in claim 9, wherein said optical guide layer has a maximum thickness which is 70 % or below of the height of said diffraction grating.

12. The method as claimed in claim 9, wherein said semiconductor layer has an operation wavelength of 0.3 µm to 1.7 µm.

13. In a method of producing a waveguide type integrated semiconductor device including a semiconductor laser that comprises a semiconductor substrate, a diffraction grating with an irregular surface formed on said semiconductor substrate, and an optical guide layer grown on said diffraction grating, a period of time over which said optical guide layer grows is selected such that said optical guide layer does not fill up valleys of said diffraction grating, and remains substantially constant without regard to a variation of height of said diffraction grating, and
    an optical waveguide forms a buried layer.

14. The method as claimed in claim 13, wherein said optical guide layer has a substantially constant sectional area in a plane containing a maximum thickness of said optical guide layer.

15. The method as claimed in claim 13, wherein said optical guide layer has a maximum thickness which is 70 % or below of the height of said diffraction grating.

16. The method as claimed in claim 13, wherein said semiconductor layer has an operation wavelength of 0.3 µm to 1.7 µm.

# FIG. 1    PRIOR ART

# FIG. 2    PRIOR ART

# FIG. 3  PRIOR ART

# FIG. 4A

# FIG. 4B

FIG. 5

$\cos(x)+1$

y

S

h

xp

-xp

x

# FIG. 6

FIG. 7

7
6
15
14
13
12
3
9

FIG. 8A

12
3

FIG. 8B

13

FIG. 8C

8
17
1
16
14

FIG. 9A

FIG. 9B

FIG. 9C

FIG. 9D

FIG. 9E

# FIG. 10

SEMICONDUCTOR
LASER PORTION

TAPERED WAVEGUIDE PORTION

EP 1 339 143 A2

EP 1 339 143 A2

# FIG. 11

SEMICONDUCTOR LASER PORTION    TAPERED WAVEGUIDE PORTION

300 μm

200 μm

100 μm

1.5 μm

5 μm

50 μm

# FIG. 12

DFB-LB PORTION                    MODULATOR PORTION